# EUROPÄISCHE PATENTSCHRIFT

(11) **EP 2 539 909 B1**
(45) Veröffentlichungstag und Bekanntmachung des Hinweises auf die Patenterteilung: **19.11.2014**
(21) Anmeldenummer: 10798520.2
(22) Anmeldetag: 23.12.2010
(51) Int. Cl.: H01H 9/00

(54) **STUFENSCHALTER**
TAP CHANGER
COMMUTATEUR À GRADINS

(30) Priorität: 24.02.2010 DE 102010008973
(43) Veröffentlichungstag der Anmeldung: 02.01.2013
(73) Patentinhaber: Maschinenfabrik Reinhausen GmbH, 93059 Regensburg (DE)
(72) Erfinder: BRÜCKL, Oliver, 93449 Waldmünchen (DE); HERTEL, Udo, 93055 Regensburg (DE); HIRTHAMMER, Armin, 93059 Regensburg (DE); SAVELIEV, Anatoli, 93197 Zeitlarn (DE)
(86) Internationale Anmeldenummer: PCT/EP2010/007934
(87) Internationale Veröffentlichungsnummer: WO 2011/103908

(56) Entgegenhaltungen:
- EP-A2- 0 124 904
- WO-A1-01/22447
- WO-A1-02/093600
- DD-A1- 40 772

## Beschreibung

Die Erfindung betrifft einen Stufenschalter mit Halbleiter-Schaltelementen zur unterbrechungslosen Umschaltung zwischen Wicklungsanzapfungen eines Stufentransformators.

Ein Stufenschalter mit Halbleiter-Schaltelementen, der als Hybrid-Schalter ausgebildet ist, ist aus der WO 01/22447 bekannt. Dieser bekannte Stufenschalter besitzt als Hybrid-Schalter einen mechanischen Teil und einen elektrischen Teil. Der mechanische Teil, der der eigentliche Gegenstand der WO 01/22447 ist, besitzt mechanische Schaltkontakte; zentraler Teil ist ein beweglicher Schiebekontakt, der entlang einer mit dem Sternpunkt verbundenen Kontakt-Laufschiene mittels eines Motorantriebes bewegt wird und dabei feststehende Kontaktelemente beschaltet. Die eigentliche Lastumschaltung selbst erfolgt durch zwei IGBT's mit jeweils vier Dioden in Grätzschaltung.
Dieses bekannte Konzept eines Hybrid-Schalters ist mechanisch anspruchsvoll, um die notwendige Lastumschaltung genau im Nulldurchgang des Laststromes sicherzustellen.

Aus der WO 97/05536 ist eine weitere IGBT-Schaltvorrichtung bekannt, bei der Anzapfungen der Regelwicklung eines Leistungstransformators über eine Reihenschaltung zweier IGBT's mit einer Lastableitung verbindbar sind. Bei dieser Anordnung ist es jedoch erforderlich, eine besondere Anpassung des Stufenschalters an den jeweiligen Stufentransformator, der beschaltet werden soll, vorzunehmen.

Das Dokument DD 40772 zeigt einen Stufenschalter gemäß dem Oberbegriff des Anspruchs 1.

Aufgabe der Erfindung ist es, einen Stufenschalter der eingangs genannten Art anzugeben, der einfach aufgebaut ist und eine hohe Funktionssicherheit aufweist. Weiterhin ist es Aufgabe der Erfindung, einen solchen Stufenschalter anzugeben, der als Standardgerät für die unterschiedlichsten Stufentransformatoren verwendbar ist, ohne dass es einer transformatorenspezifischen Anpassung bedarf.

Diese Aufgaben werden durch einen Stufenschalter mit den Merkmalen des ersten Patentanspruches gelöst. Die Unteransprüche betreffen besonders vorteilhafte Weiterbildungen der Erfindung.

Die Erfindung geht aus von zwei Halbleiter-Schalteinheiten, wobei jede Schalteinheit jeweils zwei antiparallel geschaltete IGBT's aufweist. Jedem einzelnen IGBT ist ein parallel dazu geschalteter Varistor zugeordnet. Der Varistor ist dabei so dimensioniert, dass die Varistorspannung geringer ist als die maximale Blockierspannung des jeweils parallelen IGBT's, jedoch größer als der maximale Momentanwert der Stufenspannung.

Wie bei Stufenschaltern des Hybrid-Typs üblich, werden die Halbleiter-Schalteinheiten durch mechanische Kontakte zu- bzw. abgeschaltet und sind mit der Lastableitung verbindbar.

Die Erfindung soll nachfolgend an Hand von Zeichnungen noch näher erläutert werden. Es zeigen:
- Figur 1: einen erfindungsgemäßen Stufenschalter in schematischer Darstellung
- Figur 1a: eine vergrößerte Detaildarstellung der in Figur 1 gezeigten Halbleiter-Schalteinheiten
- Figur 2: einen erfindungsgemäßen Stufenschalter in schematischer Darstellung mit alternativer Kontaktausbildung
- Figur 3: eine Schaltsequenz bei einer Umschaltung von einer Wicklungsanzapfung n auf eine benachbarte Wicklungsanzapfung n+1
- Figur 4: eine gerätetechnische Realisierung eines erfindungsgemäßen Stufenschalters in schematischer Darstellung
- Figur 5: den konstruktiven Aufbau eines solchen erfindungsgemäßen Stufenschalters in perspektivischer Darstellung
- Figur 6: eine seitliche Schnittdarstellung dazu
- Figur 7: ein beweglicher Kontaktträger eines solchen Stufenschalters allein in perspektivischer Darstellung.

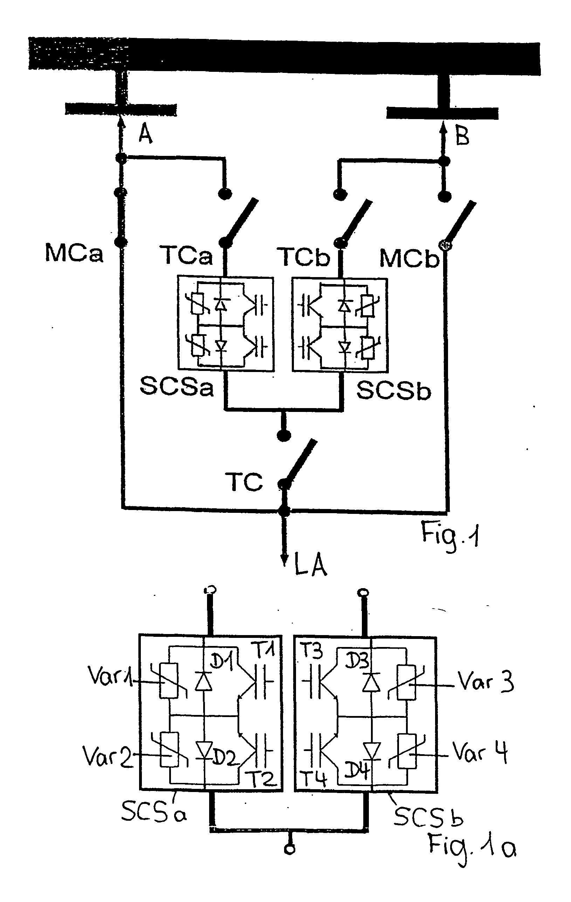

Figur 1 zeigt einen erfindungsgemäßen Stufenschalter. Dargestellt sind hier zwei Lastzweige A und B, die mit zwei Wicklungsanzapfungen eines Stufentransformators durch jeweils einen mechanischen Kontakt beschaltbar sind. Jeder der beiden Lastzweige A bzw. B weist einen mechanischen Hauptkontakt MCa bzw. MCb auf, der im stationären Betrieb den Strom des jeweils beschalteten Lastzweiges führt und eine direkte Verbindung zu einer Lastableitung LA herstellt. Parallel zum jeweiligen Hauptkontakt MCa, MCb weist jeder Lastzweig A bzw. B eine Reihenschaltung aus einem weiteren mechanischen Kontakt TCa, TCb sowie jeweils einer Halbleiter-Schalteinheit SCSa, SCSb auf. An der den jeweiligen Schaltkontakten TCa, TCb abgewandten Seite sind die Halbleiter-Schalteinheiten SCSa, SCSb elektrisch miteinander verbunden und führen zu einem mechanischen Übergangskontakt TC, dessen andere Seite mit der Lastableitung LA in Verbindung steht.
Damit ist während der Umschaltung, die weiter unten noch detailliert erläutert werden wird, es durch entsprechende Betätigung der mechanischen Kontakte TCa oder TCb sowie des Übergangskontaktes TC möglich, eine elektrische Verbindung von jedem der beiden Lastzweige A oder B über die jeweiligen Halbleiter-Schalteinheiten SCSa oder SCSb zur Lastableitung LA zu schalten.

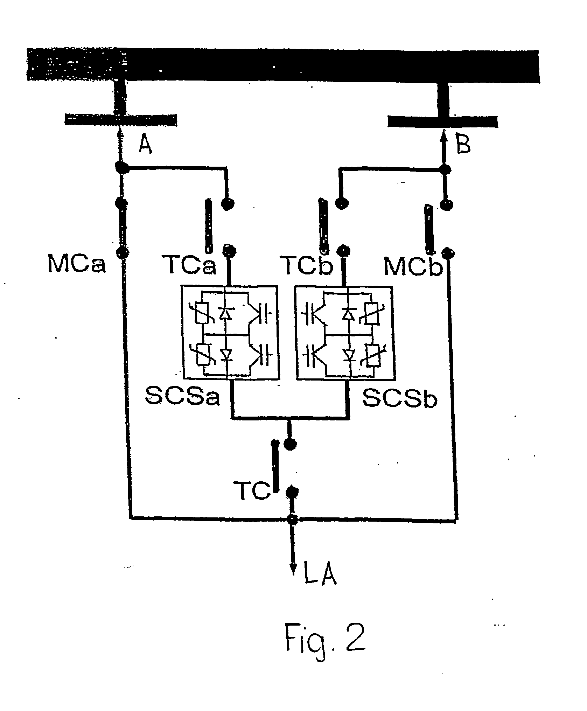

Figur 1a zeigt noch einmal die in der Figur 1 und später auch in der nachfolgenden Figur 2 jeweils rechts gezeigten elektronischen Baugruppen, d. h. Halbleiter-Schalteinheiten SCSa, SCSb in vergrößerter Darstellung. Dabei sind vier IGBT's T1...T4 gezeigt, davon in jedem Zweig zwei in Reihe gegeneinander geschaltet. Ferner ist zu jedem IGBT T1...T4 parallel eine Diode D1...D4 vorgesehen, wobei die Dioden (D1, D2; D3, D4) in jedem Zweig gegeneinander geschaltet sind. Wiederum parallel dazu ist jeweils noch ein Varistor Var1...Var4 geschaltet.
Die beiden Halbleiter-Schalteinheiten SCSa, SCSb stellen den eigentlichen Halbleiter-Schalter SCS dar. Er besteht, wie bereits erläutert, aus den folgenden Komponenten: Insgesamt sind vier IGBT's T1...T4 vorgesehen, davon in jedem Pfad zwei. Die IGBT's sind paarweise angesteuert. In dem Fall, wenn der Lastzweig bzw. Pfad A die abschaltende Seite ist, werden zuerst die IGBT's T1 und T2 eingeschaltet. Da die Stromrichtung im Umschaltmoment zufällig ist, sind die IGBT's in Reihe gegeneinander geschaltet. Während der Umschaltung auf den anderen Lastzweig bzw. Pfad B werden die IGBT's 1 und 2 ausgeschaltet und die IGBT's der anderen Seite nahezu gleichzeitig eingeschaltet. Parallel zu jedem IGBT T1...T4 sind Dioden D1...D4 vorgesehen. Wiederum parallel dazu ist jeweils noch ein Varistor Var1...Var4 geschaltet. Diese Varistoren dienen dem Entladen bzw. Laden der Streuimpedanzen (Streuinduktivität) der Transformatorstufe. Es ist zu sehen, dass die elektrische Schaltung des Halbleiter-Schalters SCS in jedem Zweig A bzw. B identisch aufgebaut ist und die beschriebenen Halbleiter-Schalteinheiten SCSa und SCSb enthält. Im unteren Teil der Figur 1a ist die elektrische Zusammenführung zu sehen, die zum hier nicht dargestellten, weiter oben erläuterten Übergangskontakt TC führt.

Figur 2 zeigt einen erfindungsgemäßen Stufenschalter mit wiederum zwei Lastzweigen A und B. Die bereits erläuterten mechanischen Kontakte TCa, TCb und TC sind hier als doppelt unterbrechende Kontakte ausgeführt.

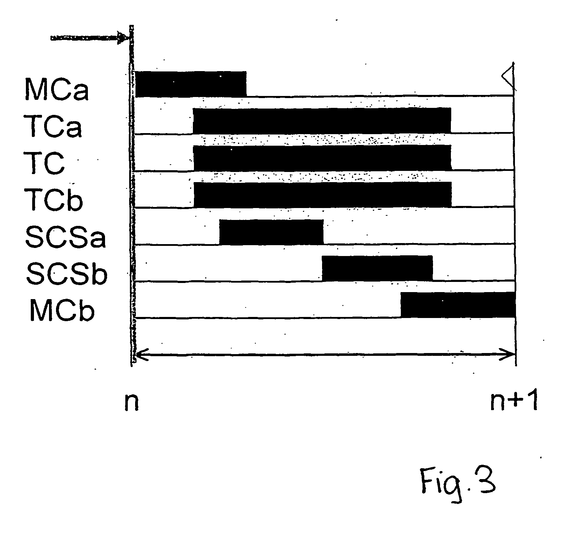

Figur 3 zeigt eine Schaltsequenz bei einer Umschaltung des Stufenschalters von n auf n+1. Dabei werden folgende Schritte vollzogen:
- Phase 1: Stationärer Betrieb an Anzapfung A. Der Strom fließt über den geschlossenen Kontakt MCa zur Lastableitung LA. Die Halbleiter-Schalteinheiten SCSa, SCSb bleiben abgeschaltet, da alle anderen mechanischen Schalter geöffnet sind.
- Phase 2: Einschalten der Elektronik. Die mechanischen Kontakte TCa, TCb und TC werden nahezu gleichzeitig eingeschaltet. Der Halbleiter-Schalter SCS wird somit über die Stufenspannung mit elektrischer Energie versorgt.
- Phase 3: Einschalten der Halbleiter-Schaltbaugruppe SCSa. Da der elektrische Widerstand der mechanischen Kontaktgruppe im Vergleich zu dem der Halbleiter-Bauelemente und der übrigen elektronischen Bauelemente niedrig ist, wird der Strom zunächst weiterhin über den mechanischen Kontakt MCa geführt.
- Phase 4: Öffnen des Hauptkontaktes MCa. Der Strom wird dadurch über die Halbleiter-Schalteinheit SCSa geführt.
- Phase 5: Die Elektronik schaltet um. Die Halbleiter-Schalteinheit SCSa wird ausgeschaltet; die Halbleiter-Schalteinheit SCSb wird eingeschaltet und übernimmt die Stromführung.
- Phase 6: Der mechanische Kontakt MCb der anderen Seite B wird eingeschaltet und übernimmt jetzt die Stromführung.
- Phase 7: Ausschalten der Halbleiter-Schalteinheit SCSb. Sobald der mechanische Kontakt MCb geschlossen ist, schaltet die Elektronik die Halbleiter-Schalteinheit SCSb dieses Zweiges ab.
- Phase 8: Ausschalten der gesamten Elektronik. Die mechanischen Kontakte TCa, TCb und TC werden dazu nahezu gleichzeitig ausgeschaltet. Alle elektronischen Komponenten werden von der Spannungsversorgung, d. h. der Stufenspannung, getrennt. Der Laststrom wird von der Seite B über den geschlossenen mechanischen Hauptkontakt MCb direkt zur Lastableitung LA geführt. Die Umschaltung ist abgeschlossen; der neue stationäre Zustand ist erreicht.

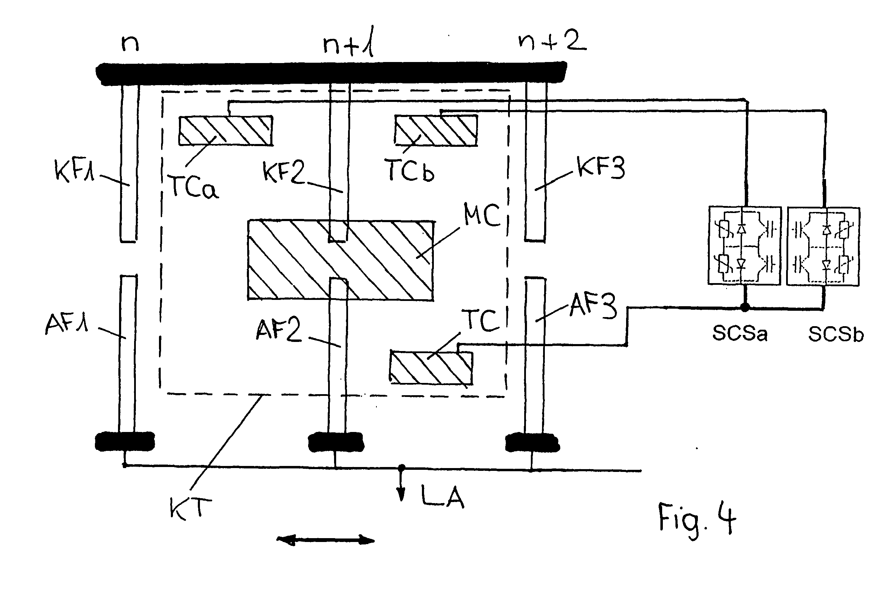

Figur 4 zeigt eine Realisierungsform des in Figur 1 bzw. 2 schematisch dargestellten erfindungsgemäßen Stufenschalters, der die in Figur 3 dargestellte Schaltsequenz bei der Umschaltung ausführt.
Hierbei sind wiederum Wicklungsanzapfungen, hier n, n+1, n+2, gezeigt, die mit langgestreckten, dünnen bleistiftartigen, festen Kontaktfingem KF1...KF3 elektrisch verbunden sind. Diesen Kontaktfingern KF1...KF3 gegenüberliegend sind jeweils weitere, ebenso ausgebildete langestreckte Kontaktfinger AF1...AF3 als Ableitfinger vorgesehen, die miteinander leitend verbunden sind und die Lastableitung LA bilden. Oberhalb der horizontal in einer Ebene liegenden Kontaktfinger KF1...KF3 und AF1...AF3 beider Seiten ist ein durch Striche hier angedeuteter Kontaktträger KT vorgesehen, der senkrecht zur Längsausdehnung der Kontaktfinger bewegbar ist. Die Bewegungsrichtung ist wiederum durch einen Pfeil symbolisiert.
Auf dem Kontaktträger KT, auf der den Kontaktfingern KF1...KF3; AF1...AF3 zugewandten Seite, sind Kontaktstücke angeordnet, die auf dem Kontaktträger KT fixiert sind und in unveränderlicher geometrischer Anordnung zueinander mit diesem bewegt werden. Dabei handelt es sich zum einen um das Kontaktstück MC, das die jeweilige Wicklungsanzapfung direkt im stationären Betrieb, der in Figur 4 gezeigt ist, mit dem gegenüberliegenden Kontaktfinger der Lastableitung LA verbindet. Zum anderen sind seitlich und symmetrisch dazu angeordnet zwei separate weitere Kontaktstücke TCa und TCb vorgesehen. Das Kontaktstück TCa steht elektrisch mit dem Eingang der ersten Halbleiter-Schalteinheit SCSa in Verbindung. Das zweite Kontaktstück TCb steht elektrisch mit dem Eingang der zweiten Halbleiter-Schalteinheit SCSb in Verbindung. Schließlich ist noch auf der anderen Seite auf dem Kontaktträger KT ein weiteres Kontaktstück TC vorgesehen, das elektrisch mit dem Ausgang der beiden Halbleiter-Schalteinheiten SCSa, SCSb verbunden ist. Die erläuterten weiteren Kontaktstücke - neben dem Kontaktstück MC - sind geometrisch derart angeordnet, dass, je nach Schaltrichtung, bei Bewegung des Kontaktträgers KT das Kontaktstück TCa bzw. TCb kurzzeitig einen der Kontaktfinger KF1...KF3 kontaktiert. Das Kontaktstück TC auf der anderen Seite ist geometrisch derart angeordnet, dass es während einer Umschaltung, d. h. Betätigung des Kontaktträgers KT, kurzzeitig Kontakt zu einem der Kontaktfinger AF1...AF3 der Lastableitung LA herstellt. Im stationären Betrieb sind alle diese Kontaktstücke TCa, TCb, TC nicht geschaltet; die elektrische Verbindung direkt von der jeweils geschalteten Wicklungsanzapfung, hier n+1, zur Lastableitung LA erfolgt ausschließlich durch das Kontaktstück MC, während die gesamte Elektronik freigeschaltet ist. Die in diesem Ausführungsbeispiel gezeigte Ausführung der in Bewegungsrichtung schmalen Kontakte, als Kontaktfinger ausgebildet, in Verbindung mit dem in Bewegungsrichtung breiten beweglichen Kontakten, als Kontaktstück jeweils ausgebildet, ermöglicht insgesamt einen besonders vorteilhaften, spannungsfesten Aufbau des erfindungsgemäßen Stufenschalters.
Die Bezeichnung der erläuterten Kontaktstücke in dieser Figur entspricht der Bezeichnung der mechanischen Schalter in Figur 1 bzw. 2, die sie repräsentieren.

Anzumerken ist, dass unabhängig vom konstruktiven Aufbau die Schaltung gemäß Figur 1 bzw. 2 und auch die Schaltsequenz gemäß Figur 3 unverändert bleiben.

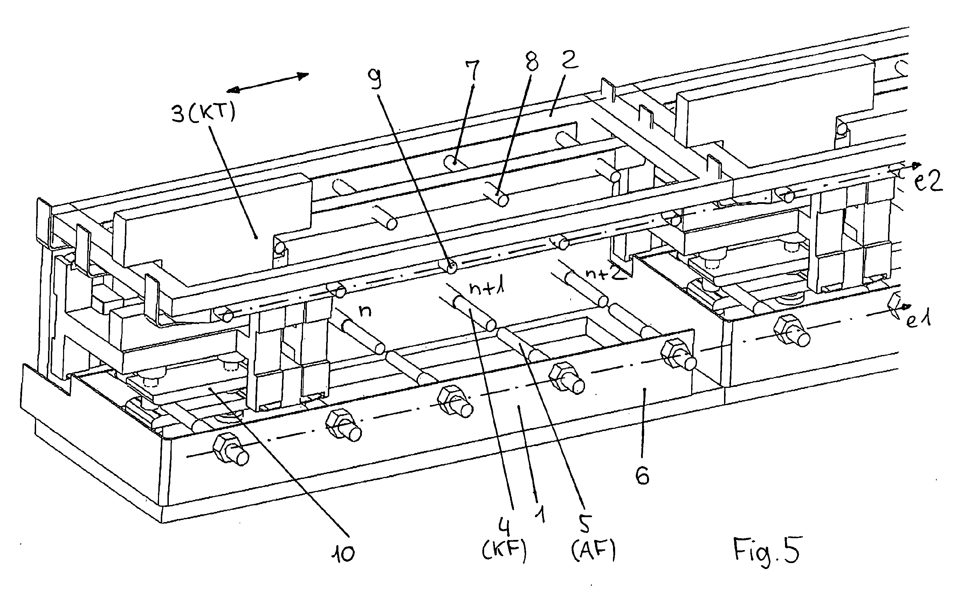

Figur 5 zeigt in schematischer, perspektivischer Darstellung den konstruktiven Aufbau. Es ist ein Gehäuse 1 mit einem oberen Gehäuseträger 2 gezeigt. Linear in Längsrichtung des Gehäuses 1 verschiebbar ist ein Kontaktträger 3 dargestellt, der in der Figur 4 als KT bezeichnet wurde. Auf den Kontaktträger 3 wird später noch detailliert eingegangen werden. In einer ersten horizontalen Ebene e1, die durch eine Strich-Punkt-Linie angedeutet ist, sind Kontaktfinger 4 vorgesehen; in Figur 4 als KF bezeichnet. Jeweils gegenüberliegend sind weitere Kontaktfinger 5 als Ableitfinger angeordnet; in der Figur 4 als AF bezeichnet. Alle Ableitfinger 5 sind mittels eines Verbindungsbleches 6 elektrisch miteinander verbunden und zur Lastableitung geführt. In einer parallel dazu angeordneten, zweiten horizontalen Ebene e2 sind auf einer Seite des Gehäuses 1 Kontaktfinger 7 angeordnet, in der Mitte, auf einem separaten Träger, weitere Kontaktfinger 8 und an der anderen Seite, wiederum der zweiten horizontalen Ebene e2, weitere Kontaktfinger 9.
Anzumerken ist, dass alle Kontaktfinger 4, 5; 7, 8, 9 im gleichen vertikalen Raster angeordnet sind; es ist jeweils von jeder Art der Kontaktfinger nur einer aus Übersichtlichkeitsgründen mit Bezugszeichen versehen. Der Kontaktträger 3 weist an seinem unteren Bereich einen zweiteiligen Hauptkontakt 10 als Kontaktstück MC auf, der den jeweils gegenüberliegenden, korrespondierenden Kontaktfinger 4 mit dem jeweiligen Ableitfinger 5 elektrisch verbindet und damit im stationären Betrieb eine direkt Verbindung zur Lastableitung herstellt, so wie das in den Figuren 1 und 2 gezeigt ist.
Die Kontaktfinger 7 sind jeweils mit dem Eingang der ersten Halbleiter-Schalteinheit SCSa elektrisch verbunden. Die Kontaktfinger 8 sind jeweils mit dem Eingang der zweiten Halbleiter-Schalteinheit SCSb verbunden. Die Kontaktfinger 9 schließlich sind mit dem gemeinsamen Ausgang beider Halbleiter-Schalteinheiten SCSa, SCSb elektrisch verbunden.
Diese elektrischen Verbindungen sind zwar in Figur 4 gezeigt, hier aus Übersichtlichkeitsgründen in der Figur 5 aber nicht dargestellt, ebenso wenig wie der Antrieb des Kontaktträgers 3.

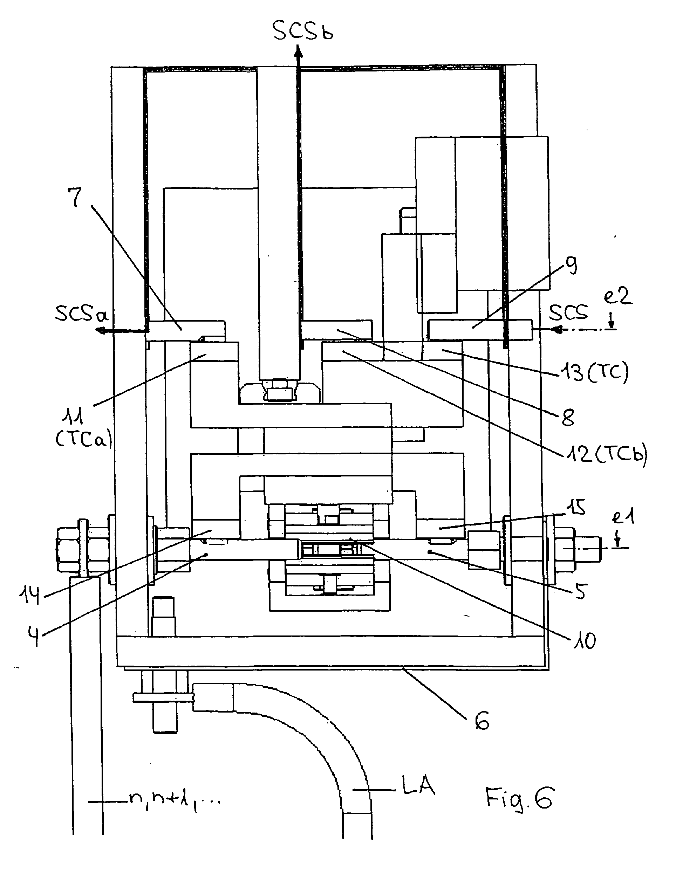

Figur 6 zeigt diese Anordnung in seitlicher Schnittdarstellung. Es ist hier deutlich zu sehen, dass die Kontaktfinger 4 und 5 in einer ersten horizontalen Ebene e1 und die Kontaktfinger 7, 8, 9 in einer zweiten horizontalen Ebene e2 angeordnet sind. Es ist ferner zu sehen, dass der Kontaktträger 3 neben dem beschriebenen Hauptkontakt 10 im oberen Bereich Kontaktstücke 11, 12 und 13 besitzt, die jeweils mit den Kontaktfingern 7 oder 8 oder 9 korrespondieren, d. h. diese beschalten können. An seinem unteren Teil besitzt der Kontaktträger 3 weitere Kontaktstücke 14, 15. Kontaktstück 14 kann den jeweiligen Kontaktfinger 4 beschalten; Kontaktstück 15 den jeweiligen Kontaktfinger 5.
Wichtig für die Funktion ist, dass die Kontaktstücke 11 und 12 elektrisch mit dem Kontaktstück 14 verbunden sind, das Kontaktstück 13 hingegen elektrisch mit dem Kontaktstück 15 in Verbindung steht.
Der Kontaktträger 3 verbindet also elektrisch Kontaktstücke 11, 12, 13 der oberen Ebene e2 mit Kontaktstücken 14,15 der unteren Ebene e1 auf ganz spezifische Weise.
Auch bei dieser Ausführungsform der Erfindung sind die Kontaktfinger 4, 5; 7, 8, 9 als in Bewegungsrichtung des Kontaktträgers 3 gesehen schmale, bleistiftartige Kontaktfinger, die nur an einem Ende befestigt sind, ausgebildet, während die Kontaktstücke 11, 12, 13; 14, 15 sowie der Hauptkontakt 10 in Bewegungsrichtung des Kontaktträgers 3 eine erheblich größere Längsausdehnung besitzen - vorzugsweise mindestens das Dreifache.

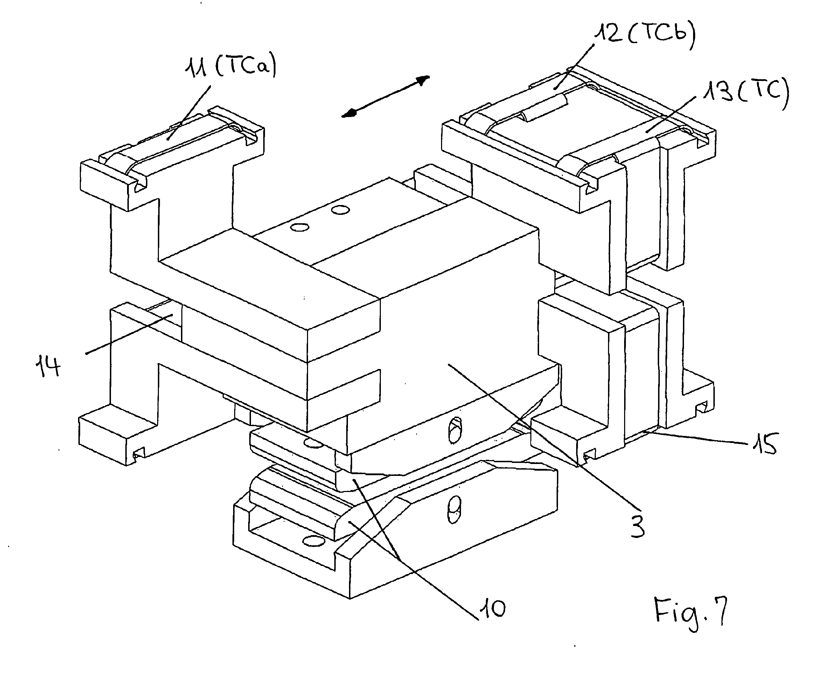

Figur 7 zeigt einen Kontaktträger 3 allein in perspektivischer Darstellung.
Es sind hier zunächst einmal die in der unteren horizontalen Ebene angeordneten seitlichen Kontaktstücke 14, 15 sowie der Hauptkontakt 10 zu sehen.
In der oberen horizontalen Ebene sind die Kontaktstücke 11, 12 und 13 gezeigt, die in Bewegungsrichtung - durch einen Pfeil angedeutet - seitlich versetzt sind.
Das Kontaktstück 11 entspricht in seiner Funktion dem Kontakt TCa: Es stellt die Verbindung zum Eingang der ersten Halbleiter-Schalteinheit SCSa her. Das Kontaktstück 12 entspricht dem Kontakt TCb: Es stellt die Verbindung zum Eingang der zweiten Halbleiter-Schalteinheit SCSb her. Das Kontaktstück 13 entspricht dem Kontakt TC: Es stellt die Verbindung mit dem gemeinsamen Ausgang beider Halbleiter-Schalteinheiten SCSa, SCSb her. Damit wird exakt der in Figur 4 schematisch dargestellte elektrische und mechanische Aufbau realisiert.

Bei einer Bewegung des Kontaktträgers 3 wird je nach Schaltrichtung die erste oder zweite Halbleiter-Schalteinheit SCSa oder SCSb über das jeweilige Kontaktstück 11, entsprechend TCa, oder 12 entsprechend TCb das jeweils mit einem festen Stufenkontakt kurzzeitig elektrisch verbunden ist, mit elektrischer Energie versorgt. Der gemeinsame Ausgang der Halbleiter-Schalteinheiten SCSa bzw. SCSb wird dann über das Kontaktstück 13, entsprechend TC, wieder zurück auf die Lastableitung geführt.

Im Ausführungsbeispiel wurden zwei horizontale Ebenen beschrieben; es ist im Rahmen der Erfindung ebenso auch möglich, die beiden Ebenen, die parallel verlaufen, vertikal anzuordnen.

Zusammengefasst lässt sich die Funktion des Kontaktträgers 3 damit folgendermaßen beschreiben: Im stationären Betrieb stellt er eine direkte Verbindung einer Wicklungsanzapfung mit der Lastableitung her, indem ein entsprechender Kontaktfinger 4 mit dem korrespondierenden Kontaktfinger 5 der Lastableitung durch den Hauptkontakt 10 elektrisch in Verbindung steht. Während der Umschaltung hingegen wird diese direkte Kontaktierung unterbrochen und durch Kontaktstücke 11 oder 12 in einer anderen horizontalen Ebene die jeweilige Halbleiter-Schalteinheit SCS1 oder SCS2 kurzzeitig eingeschaltet und deren (gemeinsamer) Ausgang durch das weitere Kontaktstück 13 wieder zurück in die erste horizontale Ebene zum Kontaktstück 15 und weiter zum Kontaktfinger 5 der Lastableitung 6 geführt.
Charakteristisch sind die eigentliche Schaltebene, d. h. die horizontale Ebene e1, sowie die Hilfsschaltebene, d. h. die Ebene e2, zum kurzzeitigen Einschalten der Halbleiter-Schalteinheiten während einer Umschaltung.

## Patentansprüche

1. Stufenschalter mit Halbleiter-Schaltelementen zur unterbrechungslosen Umschaltung zwischen Wicklungsanzapfungen eines Stufentransformators, wobei zwei Lastzweige (A, B) vorgesehen sind, die mit Wicklungsanzapfungen des Stufentransformators in Verbindung stehen,
wobei jeder der beiden Lastzweige (A, B) einen mechanischen Hauptkontakt (MCa, MCb) aufweist, der im stationären Betrieb den Strom des jeweils beschalteten Lastzweiges (A oder B) führt und eine elektrische Verbindung zu einer Lastableitung (LA) herstellt,
wobei parallel zum jeweiligen Hauptkontakt (MCa, MCb) jeder Lastzweig (A, B) eine Reihenschaltung aus einem weiteren mechanischen Kontakt (TCä, TCb) sowie jeweils einer Halbleiter-Schalteinheit (SCSa, SCSb) aufweist, wobei an den den jeweiligen Kontakten (TCa, TCb) abgewandten Seite die Halbleiter-Schalteinheiten (SCSa, SCSb) elektrisch miteinander verbunden sind **dadurch gekennzeichnet dass** an der abgewandten Seite die Halbleiter-Schalteinheiten zu einem mechanischen Übergangskontakt (TC) führen, dessen andere Seite mit einer Lastableitung (LA) in Verbindung steht
und wobei die Beschaltung der Hauptkontakte (MCa, MCb) sowie der weiteren mechanischen Kontakte (TCa, TCb, TC) durch einen bewegbaren Kontaktträger (KT) erfolgt.

2. Stufenschalter nach Anspruch 1,
**dadurch gekennzeichnet,**
**dass** in einer ersten Ebene (e1) parallel zueinander angeordnete feste Kontaktfinger (4) vorgesehen sind, die jeweils mit einer Wicklungsanzapfung (n, n+1, n+2) des Stufenschalters in Verbindung stehen,
**dass** in der gleichen Ebene gegenüberliegend weitere, ebenso ausgebildete langgestreckte Kontaktfinger (5) vorgesehen sind, die miteinander leitend verbunden sind und zur Lastableitung (LA, 6) führen,
**dass** oberhalb der in einer Ebene liegenden Kontaktfinger (4, 5) beider Seiten ein Kontaktträger (3) vorgesehen ist, der senkrecht zur Längsausdehnung der Kontaktfinger (4, 5) bewegbar ist,
**dass** auf dem Kontaktträger (3), auf der den Kontaktfingern (4, 5) zugewandten Seite, Kontaktstücke (10, 14, 15) vorgesehen sind, die mit den jeweiligen Kontaktfingern beschaltbar sind,
**dass** ein Kontaktstück (10) im stationären Betrieb die direkte elektrische Verbindung zur Lastableitung (6) herstellt,
**dass** ein weiteres Kontaktstück (11) mit dem Eingang der ersten Halbleiter-Schalteinheit (SCSa) elektrisch in Verbindung steht,
**dass** ein weiteres Kontaktstück (12) mit dem Eingang der zweiten Halbleiter-Schalteinheit (SCSb) elektrisch in Verbindung steht
und **dass** noch ein weiteres Kontaktstück (13) mit dem gemeinsamen Ausgang der beiden Halbleiter-Schalteinheiten (SCSa, SCSb) elektrisch verbunden ist.

3. Stufenschalter nach Anspruch 2,
**dadurch gekennzeichnet,**
**dass** in einer zweiten Ebene (e2) jeweils in einer Linie mehrere weitere Kontaktfinger (7, 8, 9) vorgesehen sind,
**dass** die erste Reihe von Kontaktfingern (7) mit dem Eingang der ersten Halbleiter-Schalteinheit (SCSa),
die zweite Reihe von Kontaktfingern (8) mit dem Eingang der zweiten Halbleiter-Schalteinheit (SCSb),
die dritte Reihe von Kontaktfingern (9) mit dem gemeinsamen Ausgang beider Halbleiter-Schalteinheiten SCSa, SCSb elektrisch in Verbindung steht,
**dass** durch den Kontaktträger (3) während der Umschaltung Kontaktfinger (7, 8, 9) der oberen Ebene (e2) kurzzeitig mit den jeweiligen Kontaktfingern (4, 5) in der ersten Ebene (e1) mittels weiterer Kontaktstücke (14, 15) elektrisch in Verbindung bringbar sind.

4. Stufenschalter nach Anspruch 2 oder 3,
**dadurch gekennzeichnet,**
**dass** die Längsausdehnung aller Kontaktstücke (MC, TCa, TCb, TC; 10, 11, 12, 13, 14, 15) in Bewegungsrichtung des Kontaktträgers (3) gesehen mindestens das Dreifache der Dicke der Kontaktfinger (KF1...KF3, AF1...AF3; 4, 5, 7, 8, 9) beträgt.

## Claims

1. Tap changer with semiconductor switching elements for uninterrupted switching over between winding taps of a tapped transformer, wherein two load branches (A, B) connected with winding taps of the tapped transformer are provided, wherein each of the two load branches (A, B) comprises a mechanical main contact (MCa, MCb) which in stationary operation conducts the current of the respectively connected load branch (A or B) and produces an electrical connection with a load shunt (LA), wherein each load branch (A, B) comprises parallel to the respective main contact (MCa, MCb) a series circuit consisting of a further mechanical contact (TCa, TCb) as well as a respective semiconductor switching unit (SCSa, SCSb), wherein the semiconductor switching units (SCSa, SCSb) are electrically connected together at the side remote from the respective contacts (TCa, TCb), **characterised in that** at the remote side the semiconductor switching units lead to a mechanical transfer contact (TC), the other side of which is connected with a load shunt (LA), and wherein the connection of the main contacts (MCa, MCb) as well as the further mechanical contacts (TCa, TCb, TC) is effected by a movable contact carrier (KT).

2. Tap changer according to claim 1, **characterised in that**
fixed contact fingers (4) arranged parallel to one another are provided in a first plane (e1) and are each connected with a respective winding tap (n, n+1, n+2) of the tap changer, further, similarly constructed elongate contact fingers (5) are provided oppositely in the same plane and are conductively connected together and lead to the load shunt (LA, 6),
a contact carrier (3) is provided on both sides above the contact fingers (4, 5) lying in a plane and is movable perpendicularly to the length direction of the contact fingers (4, 5), contact members (10, 14, 15) able to be connected with the respective contact fingers are provided on the contact carrier (3) on the side towards the contact fingers (4, 5),
a contact member (10) in stationary operation produces the direct electrical connection with the load shunt (6),
a further contact member (11) is electrically connected with the input of the first semiconductor switching unit (SCSa),
a further contact member (12) is electrically connected with the input of the second semiconductor switching unit (SCSb) and
yet a further contact member (13) is electrically connected with the common output of the two semiconductor switching units (SCSa, SCSb).

3. Tap changer according to claim 2, **characterised in that**
several further contact fingers (7, 8, 9) are provided respectively in a line in a second plane (e2),
the first row of contact fingers (7) is electrically connected with the input of the first semiconductor switching unit (SCSa),
the second row of contact fingers (8) is electrically connected with the input of the second semiconductor switching unit (SCSb),
the third row of contact fingers (9) is electrically connected with the common output of the two semiconductor switching units (SCSa, SCSb) and
during the switching-over process contact fingers (7, 8, 9) of the upper plane (e2) can be temporarily brought into electrical connection with the respective contact fingers (4, 5) in the first plane (e1) by the contact carrier (3) by means of further contact members (14, 15).

4. Tap changer according to claim 2 or 3, **characterised in that** the length direction of all contact members (MC, TCa, TCb, TC; 10, 11, 12, 13, 14, 15) as seen in the direction of movement of the contact carrier (3) is at least three times the thickness of the contact fingers (KF1 ... KF3, AF1 ... AF3; 4, 5, 6, 7, 8, 9).

## Revendications

1. Commutateur à gradins comprenant des éléments de commutation à semi-conducteur pour permettre d'effectuer une commutation sans interruption entre des prises de réglage d'enroulement d'un transformateur à gradins, dans lequel il est prévu deux branches de charge (A, B) qui sont reliées à des prises de réglage d'enroulement du transformateur à gradins,
chacune des deux branches (A, B) comprend un contact mécanique principal (MCa, MCb) qui, à l'état stationnaire fait circuler le courant de la branche de charge respectivement branchée (A ou B), et réalise une liaison électrique vers une dérivation de charge (LA),
parallèlement au contact principal (MCa, MCb) respectif, chaque branche de charge (A, B) comporte un montage en série d'un autre contact mécanique (TCa, TCb) et d'une unité de commutation à semi-conducteur respective (SCSa, SCSb), et, du côté opposé aux contacts (TCa, TCb) respectifs, les unités de commutation à semi-conducteur (SCSa, SCSb) sont électriquement reliées entre elles,
**caractérisé en ce que**
du côté opposé, les unités de commutation à semi-conducteur conduisent à un contact de jonction mécanique (TC) dont l'autre côté est relié à une dérivation de charge (LA), et, le branchement du contact principal (MCa, MCb) ainsi que des autres contacts mécaniques (TCa, TCb, TC) s'effectue par l'intermédiaire d'un support de contact mobile (KT).

2. Commutateur à gradins conforme à la revendication 1,
**caractérisé en ce que**
dans un premier plan (e1), il est prévu des doigts de contact fixes (4) montés parallèlement les uns aux autres qui sont respectivement reliés à une prise de réglage d'enroulement (n, n+1, n+2) du commutateur à gradins,
dans le même plan, et en regard il est prévu, d'autres doigts de contact (5) s'étendant longitudinalement réalisés de la même manière, qui sont reliés entre eux de façon à conduire le courant et conduisent la dérivation de charge (LA, 6),
au-dessus des doigts de contact (4, 5) situés dans un plan, de chaque côté il est prévu un support de contact (3) qui est mobile perpendiculairement à l'extension longitudinale des doigts de contact (4, 5),
sur le support de contact (3), du côté tourné vers les doigts de contact (4, 5) il est prévu des pièces de contact (10, 14, 15) qui peuvent être branchées avec les doigts de contact respectifs,
une pièce de contact (10) réalise à l'état stationnaire la liaison électrique directe avec la dérivation de charge (6),
une autre pièce de contact (11) est reliée électriquement à l'entrée de la première unité de commutation à semi-conducteur (SCSa),
une autre pièce de contact (12) est reliée électriquement à l'entrée de la seconde unité de commutation à semi-conducteur (SCSb), et
encore une autre pièce de contact (13) est reliée électriquement à la sortie commune des deux unités de commutation à semi-conducteur (SCSa, SCSb).

3. Commutateur à gradins conforme à la revendication 2,
**caractérisé en ce que**
dans un second plan (e2), il est respectivement prévu plusieurs autres doigts de contact (7, 8, 9) alignés sur une rangée,
la première rangée de doigts de contact (7) est électriquement reliée à l'entrée de la première unité de commutation à semi conducteur (SCSa), la seconde rangée de doigts de contact (8) est électriquement reliée à l'entrée de la seconde unité de commutation à semi-conducteur (SCSb), la troisième rangée de doigts de contact (9) est électriquement reliée à la sortie commune des deux unités de commutation à semi-conducteur (SCSa, SCSb),
par le support de contact (3), pendant la commutation, des doigts de contact (7, 8, 9) du plan supérieur (e2) peuvent être mis en contact électrique temporaire avec les doigts de contact respectifs (4, 5) situés dans le premier plan (e1) au moyen d'autres pièces de contact (14, 15).

4. Commutateur à gradins conforme à la revendication 2 ou 3,
**caractérisé en ce que**
l'extension longitudinale de toutes les pièces de contact (MC, TCa, TCb, TC, 10, 11, 12, 13, 14, 15) est égale, considérée dans la direction de déplacement du support de contact (3), à au moins trois fois l'épaisseur des doigts de contact (KF1...KF3, AF1...AF3 ; 4, 5, 7, 8, 9).
